Europäisches Patentamt

(19) European Patent Office

Office européen des brevets

(11) Publication number: 0 284 456 B1

(12) **EUROPEAN PATENT SPECIFICATION**

(45) Date of publication of patent specification:
25.09.91 Bulletin 91/39

(51) Int. Cl.⁵: **H01L 21/76**

(21) Application number: 88400389.8

(22) Date of filing: 19.02.88

(54) Pad oxide protect sealed interface isolation process.

(30) Priority: 24.02.87 US 17357

(43) Date of publication of application:
28.09.88 Bulletin 88/39

(45) Publication of the grant of the patent:
25.09.91 Bulletin 91/39

(84) Designated Contracting States:
DE ES FR GB IT NL

(56) References cited:
DE-A- 3 418 638
EXTENDED ABSTRACTS, vol. 86-2, 19th-24th
October 1986, pages 409-410, Princeton, NJ,
US; M. INUISHI et al.: "Defect free process of
a bird's beak reduced locos"
IEEE TRANSACTIONS ON ELECTRON DE-
VICES, vol. ED-32, no. 11, November 1985,
IEEE, New York, US; S. SAWADA et al.:
"Electrical properties for MOS LSI's fabri-
cated using stacked oxide SWAMI
technology"

(73) Proprietor: SGS-THOMSON
MICROELECTRONICS, INC. (a Delaware
corp.)
1310 Electronics Drive
Carrollton, TX 75006 (US)

(72) Inventor: Han, Yu-Pin
7701 Scotia Drive
Dallas-Texas (US)
Inventor: Liou, Fu-Tai
10445 N MacArthur Drive
192 Irving-Texas (US)
Inventor: Bryant, Frank R.
2125 Crestwood
Denton-Texas (US)
Inventor: Chan, Tsin C.
1633 Camero Drive
Carrolton-Texas (US)

(74) Representative: Driver, Virginia Rozanne et al
Page White & Farrer 54 Doughty Street
GB-London WC1N 2LS (GB)

# Description

This invention relates to the fabrication of semiconductive integrated circuits.

Various techniques have been used in an attempt to reduce the bird's beak when a field oxide is grown using local oxidation of silicon. One such technique is described in Extended Abstract, Vol. 86-2, 19th-24th October 1986, pages 409-410, Princeton, N.J., U.S. ; M. Innishi et al : "Defect free process of a bird's beak reduced locos". This document describes the formation of field oxide regions in integrated circuits. Nitride sidewall spacers are formed along the sides of openings in an insulating layer prior to growing field oxide. This reduces the size of the bird's beak which is formed at the edges of the field oxide region.

In US Application Serial No. 004655 filed 20th January 1987, there is described a process for forming a localized field oxided region of relatively narrow width by a process which involves forming over a silicon substrate a succession of layers including in turn a pad thermally grown silicon oxide layer, a CVD (chemical vapor deposited) silicon nitride layer, and a CVD silicon oxide layer thereafter, using photolithographic techniques for masking pattern definition, an aperture with relatively vertical side walls is formed through the outer two layers, terminating at the thermally grown oxide. Next a conformed CVD silicon nitride layer is deposited in a manner to fill the aperture rising over the edges of the aperture to extend over the surface of the CVD silicon oxide layer. This layer is then etched anisotropically to remove the thickness corresponding to the conformed silicon nitride layer to reform the aperture but leaving silicon nitride side wall spacers which effectively reduce the lateral dimensions of the aperture. The resultant is then heated in an oxidizing atmosphere to thicken the thermally grown oxide exposed in the aperture to the thickness desired for the field oxide.

This technique permits achieving field oxide regions of narrower widths than the minimum size fixture realizable by standard photolithographic techniques by the width of the side wall spacers provided after the original field oxide pattern has been defined by the photolithographic process.

The present invention relates to improvements in the basic process described.

According to one aspect of the invention there is provided a process, for use in the manufacture of integrated circuits, for forming oxide field regions between active regions of a silicon substrate the process comprising the steps of :

- forming over the silicon substrate an insulating layer,
- patterning the insulating layer to form apertures (28) for exposing the silicon substrate,
- depositing a conformal layer over the insulating layer for filling the apertures,

- etching the conformal layer to expose at each aperture a portion of the silicon substrate between side wall spacer portions of the conformal layer, and
- heating the silicon substrate to oxidize thermally at each aperture the exposed surface portion of the substrate,

characterized in that the exposed portion of the silicon substrate is etched to remove a surface layer before the deposition of the conformal layer.

According to another aspect of the invention there is provided a process, for use in the manufacture of integrated circuits, for forming oxide field regions between active regions of a silicon substrate, such process including the steps of forming an insulating layer over the silicon substrate, patterning the insulating layer to form apertures for exposing the silicon substrate, depositing a conformal layer over the insulating layer and filling the apertures, etching the conformal layer to expose at each aperture a portion of the silicon substrate between side wall spacer portions of the conformal layer, and heating the substrate to thermally oxidize in each aperture the exposed surface portion of the substrate, characterized by :

after the side wall spacer portions are formed, and before the heating step, etching the silicon substrate exposed between the side wall spacer portions to remove a surface layer thereof.

It has been found desirable to form the original aperture also through the thermally grown pad silicon oxide formed on the substrate. By this expedient, in the final structure the pad oxide under the field oxide region is eliminated and there is a consequent reduction of field oxide penetration into the active area by elimination of this oxygen diffusion path.

Moreover, as a further possible improvement, after elimination of the pad oxide in the original aperture, there is also removed a portion of the silicon substrate.

Thereafter, when the workpiece is finally oxidized to form the field oxide, there results a field oxide region which is of reduced height and also has a characteristic bird's beak of reduced length.

Moreover, as a still further improvement of this last described technique, after the reformation of the aperture narrowed by the spacer side walls, the exposed silicon substrate is further etched to form a symmetric staircase pattern in the silicon substrate. Thermal oxidation of the resulting structure leaves a field oxide of still further reduced height and a bird's beak of reduced length.

The invention will be better understood from the following more detailed description taken with the accompanying drawings in which :

FIGS 1-5 show the silicon workpiece at various stages of its processing in accordance with one embodiment of the invention,

FIGS 6-10 show the silicon workpiece at various stages of its processing in accordance with another embodiment of the invention, and

FIGS 11 and 12 show the silicon workpiece at the final two stages of a variation of the process illustrated in FIGS 6-10.

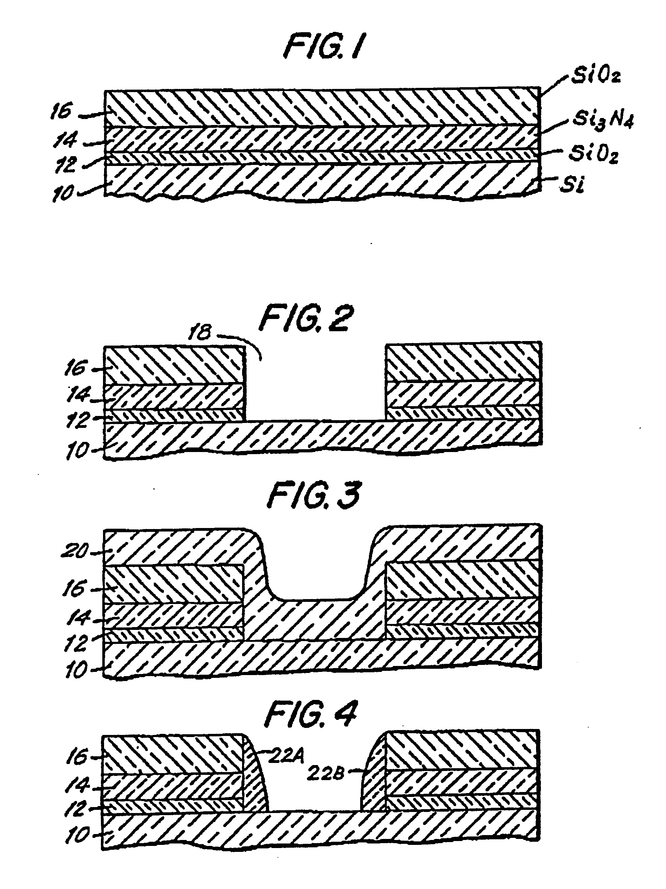

In FIG 1, there is shown a portion of a silicon monocrystalline wafer, designed to be diced into a plurality of silicon chips each embodying an integrated circuit, after suitable processing. To this end, each chip is to include a plurality of active regions in which are to be formed one or more active circuit elements and which are to be separated from one another by relatively thick field oxide regions, as is well known in the art.

The drawing will focus on the formation of only one of such thick field oxide regions to simplify the disclosure.

As shown in FIG 1, the silicon wafer has already had formed on one of its major surfaces a succession of layers including a thermally grown silicon dioxide layer 12, a silicon nitride layer 14, and a silicon dioxide layer 16. The silicon dioxide layer 12 is often described as a pad layer and it primarily serves as a stress release layer and etch stop layer of nitride etch between the silicon substrate and the silicon nitride layer that minimizes defects in the silicon substrate.

Various techniques are available for forming such an arrangement. Advantageously, the silicon nitride layer 14 is formed by a low pressure chemical vapor deposition process and the silicon dioxide layer 14 is formed by chemical vapor deposition process. Typical dimensions found suitable are about 20 nm for layer 12, 80 nm for layer 14, and 100 nm for layer 16. There then is formed an aperture or opening in the multiple layers, slightly larger than desired for the localized field oxide region desired. Typically, the aperture would be about 1.2 µm wide and considerably longer lengthwise, the direction normal to the plane of the drawing. To improve the packing density of active elements in a chip, the width of the field oxide region should be as narrow as the technology makes practical.

Various techniques are available for providing the desired aperture, generally involving photolithographic patterning of a suitable photoresist mask and subsequent etching of the pattern exposed by the mask. Since the aperture desirably should have essentially vertical side walls to save space, ion milling or anisotropic reactive ion etching (RIE) generally will be performed at the present stage of the technology.

In FIG 2, there is shown the workpiece 10 with an opening 18 which penetrates to the silicon substrate. Next there is deposited over the workpiece a conformed coating of silicon nitride 20, typically also deposited by LP CVD and the resultant is shown in FIG 3.

The thickness of the layer 20 will determine how much the aperture 18 will be narrowed so it is chosen appropriately. A thickness of between 200 and 250 nm would be typical for the particular embodiment being described.

This is then followed by anisotropic etching only until the silicon nitride layer 20 has been removed from the bottom of the central portion of the original aperture so that the etching leaves the side wall spacers 22A and 22B along the original edges of the aperture, as shown in FIG 4. As is seen in FIG 4, these spacers result in a narrowing of the width of the exposed silicon in the apertures.

Thereafter the workpiece is heated in the manner usual for forming the field oxide, which typically involves heating the workpiece in an oxidizing atmosphere for a suitable time for achieving the designed thickness, typically at least several hundred nm.

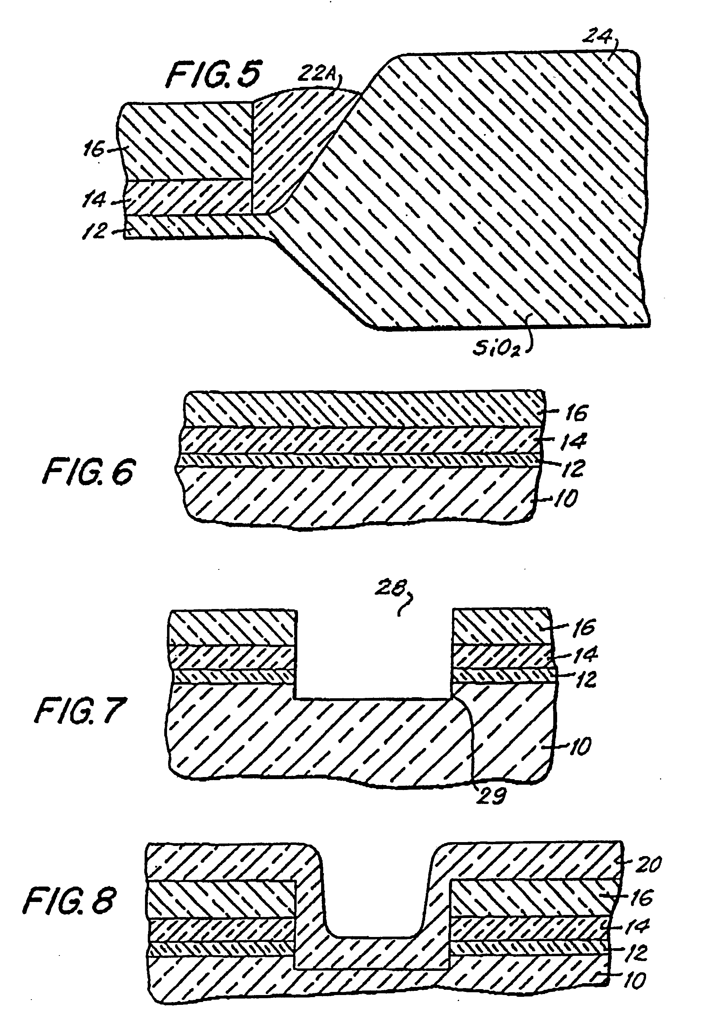

In FIG 5, on an expanded scale, there is shown one edge of the resultant field oxide region 24. As seen in this figure, the upper surface of the field oxide will rise significantly above the surface of the original silicon surface. This may pose a disadvantage particularly when the interconnect wiring for the integrated circuit comprises one or more levels of metallization over the silicon chip which are desirably as planar.

FIGS 6-10 show a modification of the basic process described which permits a field oxide thickness of the same thickness but with a reduction in the amount the top surface of the field oxide rises above the surface of the silicon substrate along the active regions between the field oxide region.

In these figures, FIG 6 corresponds to FIG 1, but as shown in FIG 7, the depth of the aperture 28 shown in FIG 7 penetrates below the original level of the silicon substrate. To this end, after baring the silicon surface by removing layers 12,14 and 16, the etching is continued either by a separate step or by a continuation of the same process when ion milling is used to form the aperture, to remove a layer of the desired thickness of the silicon substrate, shown as 29 in FIG 7. A thickness of about a hundred nm is suitable.

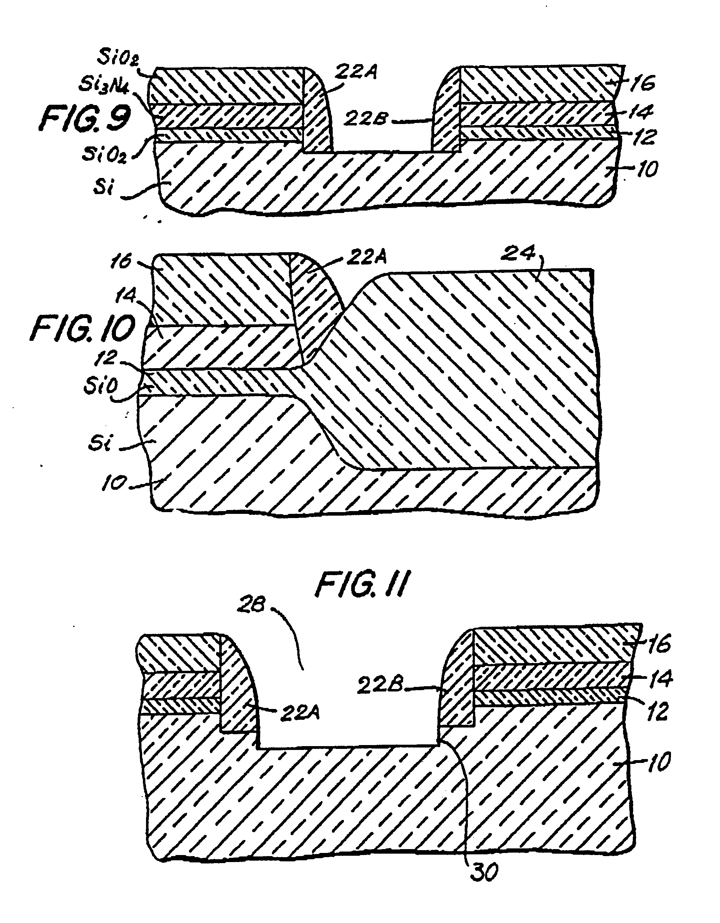

Further processing proceeds as before, involving deposition of a conformed silicon nitride layer 20 as shown in FIG 8, patterning the layer 20 to expose the silicon substrate but leaving side wall spacers 22A, 22B as seen in FIG 9, and then heating in an oxidizing atmosphere for the requisite time to form the field oxide 24 as shown in FIG 10.

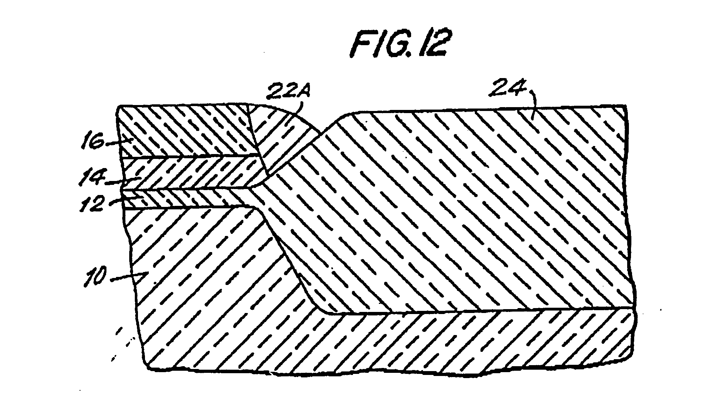

A further reduction in the effective height of the field oxide can be achieved by the modifications illustrated in FIG 11. To this end, after formation of the side wall spacers, as illustrated in FIG 9, an additional layer of the exposed silicon substrate is removed, as designated by numeral 30 in FIG 11. Again a layer of a thickness of about a hundred nm should be suitable. This layer can be removed as the earlier layer 29 was removed, for example, either by ion milling or reactive ion etching.

The resultant is shown in FIG 12 where the upper surface of the field oxide region 24 is shown as extending relatively less above the surface of the silicon surface along the active regions between field oxide regions.

It is noted that the step of etching the surface layer 29 as shown in FIG 7 may be omitted although there is later removed the surface layer 30 as depicted in FIG 11.

It can be appreciated that the particular dimensions described are merely illustrative.

Additionally, it should be apparent that other materials could be used for the various layer 12, 14-16 and 20 so long as they function appropriately. In particular, it is feasible to omit layer 16 in the process described at some sacrifice in the profile of the side spacers left after etching of the conformed layer.

Additionally, as known to workers in the art, it is usual to include in the substrate below the field oxide a heavily doped surface layer to reduce the possibility of surface inversion. The processes described can be modified to include before the thermal oxidation step one or more ion implantation steps in the usual fashion to form such heavily doped layers if desired. Moreover, when the field oxide is used to overlie the junction between P-wells and N-wells in a substrate to be used for CMOS devices, it may be desirable to include a heavily doped N-type surface layer in the N-well and a heavily doped P-type surface layer in the P-well.

## Claims

1. A process, for use in the manufacture of integrated circuits, for forming oxide field regions between active regions of a silicon substrate (10) the process comprising the steps of :
   • forming over the silicon substrate an insulating layer (12, 14, 16),
   • patterning the insulating layer to form apertures (28) for exposing the silicon substrate,
   • depositing a conformal layer over the insulating layer for filling the apertures,
   • etching the conformal layer to expose at each aperture a portion of the silicon substrate between side wall spacer portions (22A, 22B) of the conformal layer, and
   • heating the silicon substrate to oxidize thermally at each aperture the exposed surface portion of the substrate,
   characterized in that the exposed portion of the silicon substrate is etched to remove a surface layer before the deposition of the conformal layer.

2. The process of claim 1 characterized by the fact that before the thermal oxidation step the portion of the silicon substrate exposed between the side wall spacer portions (22A, 22B) of the conformal layer is etched to remove a surface layer (30).

3. A process, for use in the manufacture of integrated circuits, for forming oxide field regions between active regions of a silicon substrate (10), such process including the steps of forming an insulating layer (12, 14, 16) over the silicon substrate, patterning the insulating layer to form apertures (28) for exposing the silicon substrate, depositing a conformal layer (20) over the insulating layer and filling the apertures, etching the conformal layer to expose at each aperture a portion of the silicon substrate between side wall spacer portions (22A, 22B) of the conformal layer, and heating the substrate to thermally oxidize in each aperture the exposed surface portion of the substrate, characterized by :
   after the side wall spacer portions are formed, and before the heating step, etching the silicon substrate exposed between the side wall spacer portions to remove a surface layer (30) thereof.

4. The process of any of claims 1, 2 or 3 further characterized in that the insulating layer formed over the silicon substrate comprises a nitride layer (14) between two oxide layers (12, 16).

5. The process of claim 4, further characterized in that the conformal layer (20) comprises silicon nitride.

## Patentansprüche

1. Verfahren zur Verwendung bei der Herstellung von integrierten Schaltungen zum Ausbilden von Oxidfeldbereichen zwischen aktiven Bereichen eines Siliziumsubstrats (10), wobei das Verfahren die folgenden Schritte aufweist :
   — Ausbilden einer Isolierschicht (12, 14, 16) über dem Siliziumsubstrat,
   — Mustern der Isolierschicht, um Öffnungen (28) zum Freilegen des Siliziumsubstrats auszubilden,
   — Abscheiden einer formangeglichenen Schicht über der Isolierschicht, um die Öffnungen zu füllen,
   — Ätzen der formangeglichenen Schicht, um an jeder Öffnung einen Teil des Siliziumsubstrats zwischen Seitenwandabstandshalterteilen (22A, 22B) der formangeglichenen Schicht freizulegen, und
   — Erhitzen des Siliziumsubstrats, um an jeder Öffnung den freigelegten Oberflächenteil des Substrats thermisch zu oxidieren, dadurch gekennzeichnet, daß der freigelegte Teil des Siliziumsubstrats geätzt wird, um vor der Abscheidung der formangeglichenen Schicht eine Oberflächenschicht zu entfernen.

2. Verfahren nach Anspruch 1, dadurch gekennzeichnet, daß vor dem Schritt der thermischen Oxidation der zwischen den Seitenwandabstandshalterteilen (22A, 22B) der formangeglichenen Schicht freigelegte Teil des Siliziumsubstrats geätzt wird, um eine Oberflächenschicht (30) zu entfernen.

3. Verfahren zur Verwendung bei der Herstellung von integrierten Schaltungen zum Ausbilden von Oxidfeldbereichen zwischen aktiven Bereichen eines Siliziumsubstrats (10), wobei das Verfahren die Schritte des Ausbildens einer Isolierschicht (12, 14, 16) über dem Siliziumsubstrat umfaßt, des Musterns der Isolierschicht zum Ausbilden von Öffnungen (28), um das Siliziumsubstrat freizulegen, des Abscheidens einer formangeglichenen Schicht (20) über der Isolierschicht und des Füllens der Öffnungen, des Ätzens der formangeglichenen Schicht, um an jeder Öffnung einen Teil des Siliziumsubstrats zwischen Seitenwandabstandshalterteilen (22A, 22B) der formangeglichenen Schicht freizulegen, und des Erhitzens des Substrats, um in jeder Öffnung den freigelegten Oberflächenteil des Substrats thermisch zu oxidieren, dadurch gekennzeichnet,
daß nach dem Ausbilden der Seitenwandabstandshalterteile und vor dem Schritt des Erhitzens das zwischen den Seitenwandabstandshalterteilen freigelegte Siliziumsubstrat geätzt wird, um eine Oberflächenschicht (30) zu entfernen.

4. Verfahren nach einem der Ansprüche 1, 2 oder 3, weiter dadurch gekennzeichnet, daß die über dem Siliziumsubstrat ausgebildete Isolierschicht eine Nitridschicht (14) zwischen zwei Oxidschichten (12, 16) aufweist.

5. Verfahren nach Anspruch 4, weiter dadurch gekennzeichnet, daß die formangeglichene Schicht (20) Siliziumnitrid aufweist.

**Revendications**

1. Procédé destiné à être utilisé dans la fabrication de circuits intégrés pour former des régions d'oxyde de champ entre des régions actives d'un substrat de silicium (10), ce procédé comprenant les étapes suivantes :
   former sur le substrat de silicium une couche isolante (12, 14, 16) ;
   graver la couche isolante pour former des ouvertures (28) pour exposer le substrat de silicium ;
   déposer une couche conforme au-dessus de la couche isolante pour remplir les ouvertures ;
   graver la couche conforme pour exposer au niveau de chaque ouverture une partie du substrat de silicium entre des parties d'espaceurs latéraux (22A, 22B) de la couche conforme, et
   chauffer le substrat de silicium pour oxyder thermiquement au niveau de chaque ouverture la partie superficielle exposée du substrat ;
   caractérisé en ce que la partie exposée du substrat de silicium est gravée pour enlever une couche superficielle avant le dépôt de la couche conforme.

2. Procédé selon la revendication 1, caractérisé par le fait que l'étape d'oxydation thermique de partie du substrat de silicium exposée entre des parties d'espaceurs latéraux (22A, 22B) de la couche conforme est gravée pour enlever une couche superficielle (30).

3. Procédé destiné à être utilisé à la fabrication de circuits intégrés pour former des régions d'oxyde de champ entre des régions actives d'un substrat de silicium (10), ce procédé comprenant les étapes de formation d'une couche isolante (12, 14, 16) au-dessus du substrat de silicium, de gravure de la couche isolante pour former des ouvertures (28) pour exposer le substrat de silicium, de dépôt d'une couche conforme (20) sur la couche tampon isolante des ouvertures, de gravure de la couche conforme pour exposer au niveau de chaque ouverture une partie du substrat de silicium entre les parties d'espaceurs latéraux (22A, 22B) de la couche conforme, et de chauffage du substrat pour oxyder thermiquement dans chaque ouverture la partie superficielle exposée du substrat, caractérisé par l'étape suivante :
après formation des parties d'espaceurs latéraux et avant l'étape de chauffage, graver le substrat de silicium exposé entre les parties d'espaceurs latéraux pour en enlever une couche superficielle (30).

4. Procédé selon l'une quelconque des revendications 1, 2 ou 3, caractérisé en outre en ce que la couche d'isolement formée au-dessus du substrat de silicium comprend une couche de nitrure (14) entre deux couches d'oxyde (12, 16).

5. Procédé selon la revendication 4, caractérisé en outre en ce que la couche conforme (20) comprend du nitrure de silicium.

FIG. 1

FIG. 2

FIG. 3

FIG. 4

FIG.5

FIG.6

FIG.7

FIG.8

SiO₂

Si₃N₄

*FIG.9*

SiO₂

Si

22A

22B

16

14

12

10

16

14

12

SiO

Si

10

22A

24

*FIG. 10*

*FIG. II*

28

22A

22B

16

14

12

10

30

FIG. 12